# EUROPEAN PATENT APPLICATION

(11) **EP 3 457 511 A1**
(43) Date of publication of application: **20.03.2019**
(21) Application number: 18195018.9
(22) Date of filing: 18.09.2018
(51) Int. Cl.: H02J 1/00, G06F 1/26, H02J 13/00, H02M 3/157

(54) **POWER CONVERSION SYSTEM AND CONTROLLING METHOD THEREOF**

(30) Priority: 18.09.2017 CN 201710842072
(71) Applicant: General Electric Company, Schenectady, NY 12345 (US)
(72) Inventor: SHE, Hongwu, 201203 ShangHai, ShangHai (CN); JIANG, Xin, 201203 ShangHai, ShangHai (CN); SHEN, Jie, 201203 ShangHai, ShangHai (CN); ZHU, Dan, 201203 ShangHai, ShangHai (CN); LI, Xiaohong, 12309 New York (US); DAI, Jian, 12309 New York (US); SCHROEDER, Stefan, 12309 New York (US)
(74) Representative: Serjeants LLP

(57) **Abstract**

A power conversion system (100) is disclosed. The system comprises at least one conversion unit (10) with a converter unit (11) and a power interface board (or PIB) (12). The system (100) further comprises at least one measurement unit (20) with a measurement board (21) and a PIB (22). A controller (30) includes a processing unit (31) and a PIB (32) in communication with the processing unit (31) and with the PIBs (12, 22) of the conversion unit (10) and the measurement unit (30) with independent bandwidth.

## Description

### BACKGROUND

This disclosure relates generally to a power electronic system, and more particularly to a power conversion system and controlling method thereof.

The power conversion system may convert electric energy from AC to DC or DC to AC or may merely change the voltage or frequency. Power conversion systems are often used in wind and solar power systems, for example. Control systems are used to control the power conversion systems. Conventional control systems have limited control frequency. With the increasing development of wide-band-gap (WBG) power semiconductor devices for use in power conversion systems, higher control frequency is required to fully exploit the benefit of these devices.

### BRIEF DESCRIPTION

In one embodiment, the present disclosure provides a power conversion system which comprises at least one conversion unit comprising a converter unit and a first power interface board; at least one measurement unit comprising a measurement board and a second power interface board; and a controller comprising a processing unit and a third power interface board for communicating with the processing unit, the first power interface board, and the second power interface board, wherein at least some of the communications between the third power interface board and the first and second power interface boards have independent bandwidths.

The third power interface board may be configured for communicating with the processing unit at over 1Gbps communication or data exchange speed.

The third power interface board may be configured for communicating with the processing unit via a peripheral component interconnect express interface.

The third power interface board may be configured for communicating with the first power interface board and the second power interface board via dual fiber duplex communication.

The converter unit may comprise at least one SiC MOSFET switch.

In another embodiment, the present disclosure provides a method of controlling a power conversion system comprising: (1) sampling analog signals from a converter unit and a measurement board and converting the converter unit and measurement unit analog signals to converter unit and measurement unit data; (2) sending the converter unit data from a first power interface board to a third power interface board and sending the measurement unit data from a second power interface board to the third power interface board; (3) sending the converter unit and measurement unit data from the third power interface board to a processing unit; (4) calculating switching states and corresponding timers of the converter unit via the processing unit; (5) sending a corresponding command signal to the third power interface boards and then to the first power interface board; and (6) executing the corresponding command signals at the converter unit.

The step of executing the corresponding command signals at the converter unit may be at same time or at different time with repeating step of sampling analog signals from a converter unit and a measurement board.

The converter unit and measurement unit data may be respectively sent from the first power interface board and the second power interface board to the third power interface board via dual fiber duplex communication.

The converter unit and measurement unit data may be sent to the processing unit through a PCIe interface.

In another embodiment, the present disclosure provides a control system, comprising at least one first power interface board; at least one second power interface board; and a controller comprising a processing unit, and a third power interface board for communicating with the processing unit at over 1Gbps communication or data exchange speed, and communicated with the first power interface board and the second power interface board.

### DRAWINGS

These and other features, aspects, and advantages of the present disclosure will become better understood when the following detailed description is read with reference to the accompanying drawings in which like characters represent like parts throughout the drawings, wherein:
Fig. 1 is a diagrammatical representation of a power conversion system, in accordance with an embodiment of the present disclosure;
Fig. 2 is a controlling method of a power conversion system, in accordance with an embodiment of the present disclosure;
Fig. 3 is a timing diagram of a controlling system of the power conversion system, in accordance with an embodiment of the present disclosure.

### DETAILED DESCRIPTION

Embodiments of the present disclosure will be described herein below with reference to the accompanying drawings. In the following description, well-known functions or constructions are not described in detail to avoid obscuring the disclosure in unnecessary detail.

Unless defined otherwise, technical and scientific terms used herein have the same meaning as is commonly understood by one of ordinary skill in the art to which this disclosure belongs. The terms "first," "second," and the like, as used herein do not denote any order, quantity, or importance, but rather are used to distinguish one element from another. Also, the terms "a" and "an" do not denote a limitation of quantity, but rather denote the presence of at least one of the referenced items. The terms such as "front," "back," "bottom," and/or "top," unless otherwise noted, are merely used for convenience of description, and are not limited to any one position or spatial orientation. The term "or" is meant to be inclusive and mean either or all of the listed items. The use of "including," "comprising," or "having" and variations thereof herein are meant to encompass the items listed thereafter and equivalents thereof as well as additional items. The terms "connected" and "coupled" are not restricted to physical or mechanical connections or couplings, and can include electrical connections or couplings, whether direct or indirect.

Embodiments of the present disclosure may be described herein in terms of functional components and various processing steps. It should be appreciated that such functional components may be realized by any number of hardware, software, and/or firmware components configured to perform the specific functions. For example, an embodiment of the present disclosure may employ various integrated circuit components, e.g., memory elements, digital signal processing elements, logic elements, look-up tables, and the like, which may carry out a variety of functions of a "controller" under the control of one or more microprocessors or other control devices. In addition, embodiments of the present disclosure may be practiced in conjunction with any number of data transmission protocols. Moreover, the system described herein merely illustrates one exemplary embodiment.

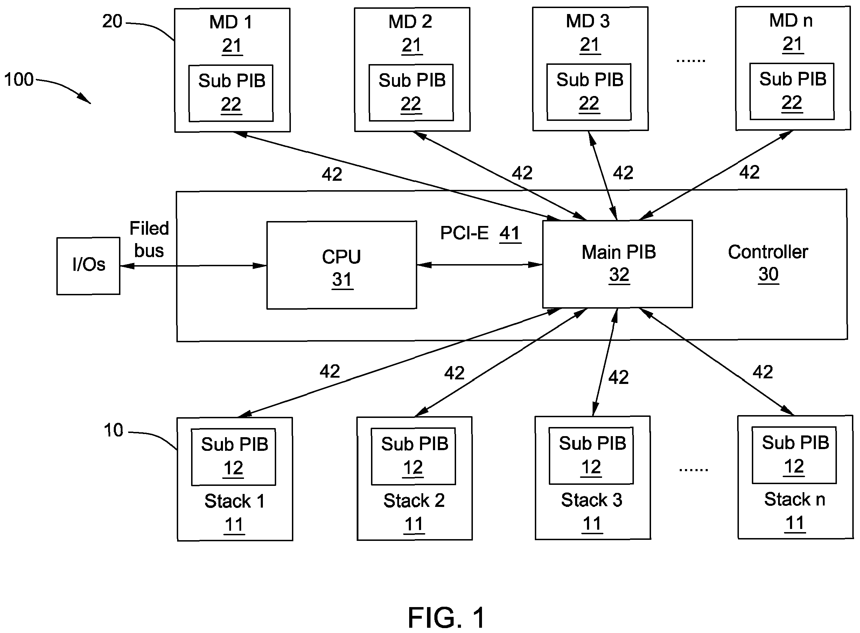

Referring to Fig. 1 of the drawings, a power conversion system 100 comprises at least one conversion unit 10 comprising a converter unit 11 and a first power interface board 12; at least one measurement unit 20 comprising a measurement board 21 and a second power interface board 22; and a controller 30 comprising a processing unit 31 and a third power interface board 32 in communication with the processing unit 31, the first power interface board 12 and the second power interface board 22, wherein at least some of the communications between the third power interface board 32 and the first and second power interface boards 12, 22 have independent bandwidths. Unlike conventional power conversion communication methodologies wherein (all) communication lines share the same bandwidth, in embodiments described herein independent bandwidths are used. By using independent bandwidths, the system control rate is increased. In one specific embodiment, at least some communications between the third power interface board 32 and the various first and second power interface boards are done at independent bandwidths. In a more specific embodiment, each of the communications between the third power interface board 32 and the various first and second power interface boards are done at independent bandwidths. As used herein "independent bandwidths" means point to point communication without bandwidth sharing between different modules.

The processing unit 31 may further include a central processing unit (CPU) 31, or a field programmable gate array (FPGA) or any other electronic unit that is capable of processing data. The third power interface board 32 may also be referred to as a main power interface board (Main PIB), and similarly the first power interface board 12 and the second power interface board 22 may be referred to as sub power interface boards (Sub PIB). For ease of viewing, the conversion units are labeled as stack 1, 2, 3...n, and the measurement boards are labeled as MD 1, 2, 3...n. The first, second and third PIB have data transmission functions. The first power and second power interface boards 12 and 22 convert analog data to digital data and vice versa. In order to achieve the data conversion functions, the first and second PIB may include a control unit such as a CPU, FPGA (field programmable gate array) or any other electronic units to control data and signals.

The third power interface board 32 may communicate with the processing unit 31 via a high speed interface (not shown) such as a multi-lane peripheral component interconnect express interface (PCIe) 41 at over 1Gbps communication or data exchange speed, which can achieve a speed up to 10Gbps in this embodiment. PCI Express (Peripheral Component Interconnect Express), officially abbreviated as PCIe or PCI-e, is a high-speed serial computer expansion bus standard, which is available on mainstream personal computers. A lane is comprised of two differential signaling pairs, with one pair for receiving data and the other for transmitting. Thus, each lane includes four wires or signal traces. Conceptually, each lane is used as a full-duplex byte stream, transporting data packets in eight-bit "byte" format simultaneously in both directions between endpoints of a link. Physical PCI Express links may contain from one to 32 lanes, more precisely 1, 2, 4, 8, 12, 16 or 32 lanes. The PCIe is adopted for high speed communication between the CPU and the Main PIB.

The third power interface board 32 may communicate with the first and second power interface board 12 and 22 via fiber-optical communication with 1, 2, 3 or more links, such as dual fiber duplex communication 42. In one embodiment of the disclosure, 100MHz or higher baud rate is used for this communication. The dual fiber duplex communication 42 uses duplex fiber cable. A duplex fiber cable comprises two strands of glass or plastic fiber. Typically found in a "zipcord" construction format, this cable is most often used for duplex communication between devices where a separate transmit and receive are required. In this duplex communication, it has a mechanism of data error check and data will be resent when error happens.

In one embodiment, each converter unit 10 comprises an A/D circuit for converting AC to DC or converting DC to AC, which includes at least one silicon carbide (SiC) MOSFET device therein, such as SiC MOSFET H-bridge devices. In one embodiment, the converter unit employs a hybrid (a mixed three-phase and single phase topology coupled with mixed SiC and Si devices), an AC-DC stage that includes a plurality of single phase AC-DC converters, and a three-phase AC-DC converter. In another embodiment, the converter unit comprises a traditional conversion unit with at least one Si device replaced with a SiC device, such as SiC MOSFET, SiC IGBT, SiC Schottky, PiN and JBS diodes, which can enable a faster switching speed comparing to the Si device.

Each converter unit 10 communicates with the Main PIB in the controller using dual fiber duplex communication 42. In each PWM (pulse width modulation) period, the sampled analog signals of voltage, current, or/and etc. in the converter unit 10 are converted into digital data and the digital data is encoded to arrange digital data for data transmission, and then sent from the Sub PIB 12 to the Main PIB 32. Encoding can be either address+data structure, or arranged with compression/encryption, etc. For example, 2 ADC channels are used for voltage and current sensing. Then 2 ADC conversions are used to sample both voltage (V) and current (I). During transmitting V and I information to the controller, the encoding of the data, such as address added into the data can differentiate the V and I information. Furthermore, the switching states and/or corresponding timers are sent from the Main PIB 32 to the Sub PIB 12 and/or the Sub PIB 22. The Sub PIB 12 decodes the command signals including switching states and timers for PWM switching in each conversion unit. The measurement board receives the switching states and/or corresponding timers from Sub PIB 22 as feedback.

Measurement boards 21 which are called dedicated measurement boards in this embodiment are used for signal sampling outside the conversion unit, e.g. measurements of the input grid voltage/current, the encoder position/speed, etc. Dual fiber duplex communication 42 adopting duplex fiber cable is also used for the communication between the measurement boards and the Main PIB.

In another embodiment of the disclosure, multiple Main PIBs 32 are included in the controller for scalability, and each Main PIB communicates with the CPU 31 with PCIe 41. A field bus (e.g., EtherCAT, Modbus, Profibus, etc.) communication port may be included in the controller for low speed digital/analog input/output interface, such as relay, contractors, circuit breakers, and temperature measurement.

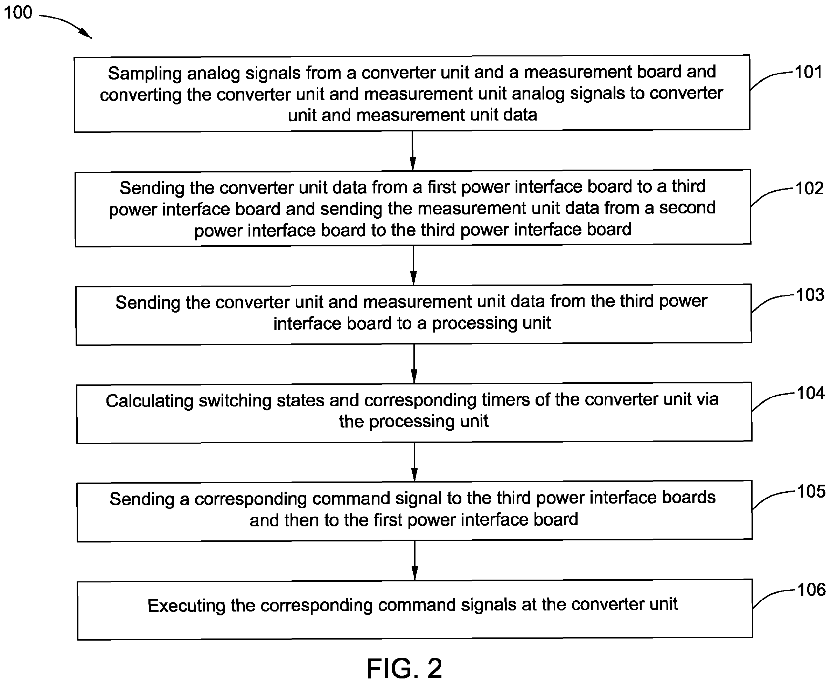

Referring to Fig. 2 of the drawings, a controlling method of a power conversion system 100, comprises steps of 101) sampling analog signals from a converter unit and a measurement board and converting the converter unit and measurement unit analog signals to the converter unit and measurement unit data; 102) sending the converter unit data from the first power interface board to the third power interface board and sending the measurement unit data from a second power interface board to the third power interface board; 103) sending the converter unit and measurement unit data from the third power interface board to a processing unit; 104) calculating switching states and corresponding timers of the converter unit via the processing unit; 105) sending a corresponding command signal to the third power interface boards and then to the first power interface board; and 106) executing the corresponding command signals at the converter unit. Before step of 101), a third power interface board sends an initial signal to a first power interface board coupled to a converter unit to initialize a PWM modulation, so that the start of the cycle of steps 101) to 105) is triggered. A timer/counter can be set inside the controller or Sub PIB. When the controller sends the initial signal to initialize a new cycle, the counter/timer starts to tick. When it's time to sample, the Sub starts ADCs (Analog to Digital Converter) to sample voltage/current/temperature/etc. and return those data back to the controller for next status calculation.

The controlling method of a power conversion system may further comprise decoding the command signal before step of executing the command signal of switching states and corresponding timers to the converter unit. Repeating steps 101) to 105) can be at same time or at different time with step of executing the corresponding command signals at the converter unit. In one example, the step of executing the corresponding command signals at the converter unit and step of sampling analog signals from a converter unit and a measurement board can be done simultaneously. In step 102), the converter unit and measurement unit data is encoded before sending, and the converter unit and measurement unit data is sent to the third power interface board through optical fiber based serial communication from the first power interface board and the second power interface board, such as through dual fiber duplex communication. In step 103) the converter unit and measurement unit data is sent to the processing unit through a PCIe interface with the DMA (Direct Memory Access) approach. The success of DMA data transmission will enable an interrupt request to the CPU, and then the CPU starts to calculate the switching states and corresponding timers of the converter unit based on the sampled data after the interrupt response time, to send them to the third power interface board, and to then send them to the first power interface board to be executed. The processing unit uses a control algorithm to calculate PWM switching states and timers, which uses target status information, current state information and sampled data information for calculation.

With the illustrated star-type topology and communication method, all stacks and measurement boards may have independent communications which enable enough bandwidth for data transmission, so that high control frequency, high insulation capability, high modularity, high reliability, low assembly effort and cost can be realized.

Referring again to Fig. 1 of the drawings, the present disclosure also discloses a controlling system for controlling a power converter unit, which comprises a first power interface boards 12 for coupling with a power converter unit; a second power interface board 22 for coupling with a measurement board; and a controller 30 comprising a processing unit 31 and a third power interface board 32 in communication with the processing unit 31 at over 1Gbps communication or data exchange speed and further in communication with the first power interface boards 12 and the second power interface boards 22.

The third power interface board 32 is in communication with the processing unit 31 via a multi-lane peripheral component interconnect express (PCIe) interface 41 or data exchange in another embodiment. The third power interface board 32 communicates with the first power interface board 12 via fiber-optical communication, such as dual fiber duplex communication 42. The third power interface board 32 also communicates with the second power interface board 22 via fiber-optical communication.

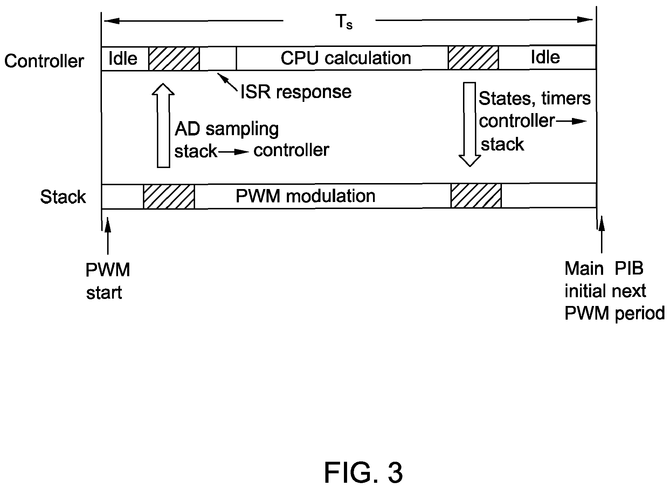

Fig. 3 shows a timing diagram of the controlling system. The start of the timing is determined by the Main PIB of the controller sending an initial signal to the Sub PIB. If more than one Main PIB exists in a controller, the timing will be determined by the first Main PIB. At the beginning of each PWM period, the Main PIB sends a flag to all stacks (Stack 1, Stack 2, ... Stack n) to initialize PWM modulation, and at the same time all the stacks (Stack 1, Stack 2, ... Stack n) and the measurement boards (MD 1, MD 2, ... and MD n) start to sample the analog signals. After the completion of the A/D conversion, the sampled data is sent to the Main PIB through the optical fiber based serial communication. Then the Main PIB packs the sampled data from all stacks and measurement boards before sending to the CPU through the PCIe interface with the DMA (Direct Memory Access) approach.

The success of DMA data transmission will enable an interrupt request to the CPU, and then the CPU may start to calculate the voltage command of the converter unit based on the sampled data after the interrupt response time. After completion of the calculation, the switching states and corresponding timers of the converter unit will be sent to the Main PIB through the PCIe and DMA approach, and then the switching states and corresponding timers will be sent to each stack. At the beginning of the next PWM period, the received switching states and corresponding timers will be executed and the next A/D sampling started simultaneously.

The time breakdown in each PWM period is illustrated below as shown in Figure 3.

### 1. The ISR response time

The ISR (Interrupt Service Routine) response time is determined by two factors: the processing unit and the OS (Operation System). In one embodiment of this disclosure, the processor is high performance processor, which could be x86-based CPU, x64-based CPU, PowerPC-based CPU, ARM based processor, or DSP, etc. In another embodiment of this disclosure, the OS is real-time operation system, which could be VxWorks, QNX, µCOS, or BME (Tare Metal Environment), etc.

### 2. The calculation time

In one embodiment of this disclosure, the processing unit is high performance processor, which could be x86-based CPU, x64-based CPU, PowerPC-based CPU, ARM based processor, or DSP, etc. With the high-performance processor, the given calculation program can be finished quickly.

### 3. The communication between the CPU and the Main PIB

The PCIe is adopted for the high-speed communication between the CPU and the Main PIB. Currently the PCIe 3.0 x4 can enable throughput as high as 3.938GB/s, thus bidirectional 4000 Byte data can be transmitted with about only 1µs.

### 4. The communication between the Main PIB and the Sub PIBs

With the star-type topology, the Main PIB communicates with all the Sub PIBs simultaneously via dual fiber duplex communication. Bidirectional 100 bit data can be transmitted with about only 1µs.

With the increasing development of the wide-band-gap (WBG) power semiconductor devices (e.g., SiC, GaN, etc.), higher control frequency is required to fully exploit the benefit of these devices. This disclosure is an enabler for the next generation power conversion system based on high switching frequency WBG semiconductor devices.

While the disclosure has been illustrated and described in typical embodiments, it is not intended to be limited to the details shown, since various modifications and substitutions can be made without departing in any way from the spirit of the present disclosure. As such, further modifications and equivalents of the disclosure herein disclosed may occur to persons skilled in the art using no more than routine experimentation, and all such modifications and equivalents are believed to be within the spirit and scope of the disclosure as defined by the following claims.

## Claims

1. A power conversion system (100), comprising:
at least one conversion unit (10) comprising a converter unit (11) and a first power interface board PIB (12);
at least one measurement unit (20) comprising a measurement board (21) and a second PIB (22); and
a controller (30) comprising,
a processing unit (31), and
a third PIB (32) for communicating with the processing unit (31) and for communicating with the first PIB (12) and the second PIB (22);
wherein at least some of the communications between the third PIB (32) and the first and second PIBs (12, 22) have independent bandwidths.

2. A system according to claim 1, wherein the third PIB (32) is configured for communicating with the processing unit (31) at over 1Gbps communication or data exchange speed e.g., up to about 10Gbps.

3. A system according to claim 1 or claim 2, wherein the third PIB (32) is configured for communicating with the processing unit (31) via a peripheral component interconnect express PCIe interface (41).

4. A system according to any preceding claim, wherein the third PIB (32) is configured for communicating with the first PIB (12) and the second PIB (22) via dual fiber duplex communication (42).

5. A system according to any preceding claim, wherein the converter unit (11) comprises at least one SiC MOSFET switch.

6. A method of controlling a power conversion system (100), comprising:
sampling analog signals from a converter unit (11) and a measurement board (21) and converting the converter unit and measurement unit analog signals to converter unit and measurement unit data;
sending the converter unit data from a first PIB (12) to a third PIB (32) and sending the measurement unit data from a second PIB (22) to the third PIB (32);
sending the converter unit and measurement unit data from the third PIB (32) to a processing unit (31);
calculating switching states and corresponding timers of the converter unit (11) via the processing unit (32);
sending a corresponding command signal to the third PIB (32) and then to the first PIB (12); and
executing the corresponding command signals at the converter unit (11).

7. A method according to claim 6, wherein the step of executing the corresponding command signals at the converter unit (11) is at same time or at different time with repeating step of sampling analog signals from the converter unit (11) and the measurement board (21).

8. A method according to claim 6 or claim 7, wherein the converter unit data and measurement unit data is respectively sent from the first PIB (12) and the second PIB (22) to the third PIB (32) via dual fiber duplex communication (42).

9. A method according to any of claims 6 to 8, wherein the converter unit data and measurement unit data is sent to the processing unit (31) through a PCIe interface (41).

10. A control system, comprising:
at least one first PIB (12);
at least one second PIB (22); and
a controller (30) comprising,
a processing unit (31), and
a third PIB (32) for communicating with the processing unit (31) via a PCIe interface (41) and communicating with the first PIB (12) and the second PIB (22) via dual fiber duplex communication (42).
